# EUROPEAN PATENT SPECIFICATION

(11) **EP 0 883 915 B1**
(45) Date of publication and mention of the grant of the patent: **28.06.2000**
(21) Application number: 97902545.9
(22) Date of filing: 26.02.1997
(51) Int. Cl.: H01R 24/00, H01R 12/14

(54) **METHOD FOR PRODUCING A CONNECTION OF DATA TRANSMISSION LINES, AND PLUG CONNECTOR**
VERBINDUNGSVERFAHREN FÜR DATATRANSMISSIONSLINIEN UND STECKVERBINDER
PROCEDE DE PRODUCTION D'UNE CONNEXION DE LIGNES DE TRANSMISSION DE DONNEES, ET CONNECTEUR MALE

(30) Priority: 28.02.1996 DE 19607534
(43) Date of publication of application: 16.12.1998
(73) Proprietor: THE WHITAKER CORPORATION, Wilmington, Delaware 19808 (US)
(72) Inventor: SOES, Lucas, NL-5248 BB Rosmalen (NL)
(74) Representative: Heinz-Schäfer, Marion
(86) International application number: IB9700168
(87) International publication number: WO9732367

(56) References cited:
- EP-A- 0 635 912
- GB-A- 2 183 111
- US-A- 4 824 399
- US-A- 5 470 244
- US-A- 5 586 914
- PATENT ABSTRACTS OF JAPAN vol. 003, no. 149 (E-157), 8 December 1979 & JP 54 128246 A (FUJITSU LTD), 4 October 1979,

## Description

The invention relates to a method for producing a connection of data transmission lines and to a plug connector, in particular for use in such a method. Fluctuations in the production methods mean that two conductors in a line are never completely identical. When such lines are used for data transmission in the microwave range, these fluctuations lead to so-called propagation delay differences between the signals on individual conductors of a line. The higher the frequency and the higher the data rate, the greater is the risk of interference due to erroneous data transmission.

EP 635 912 A1 discloses a right-angled connector having a plurality of terminals with longer and shorter tail portions. By positioning a dielectric member alongside the shorter tail portions the dielectric constant and also the propagation delay thereof is increased.

JP 54 128 246 A suggests a delay time adjusting method using an appropriate stretching device for stretching out a delay line, made of an extendible conductive material, while measuring the delay time.

US 5,470,244 specifies an arrangement and a method for preventing interference due to crosstalk. For this purpose, individual conductor tracks are interrupted within a multipole electrical plug connector and the interrupted connections are rearranged in a second position, which is arranged above the first conductor tracks. Capacitive and inductive coupling are achieved by superposition and by parallel routing of specific conductor pairs.

Taking this prior art as a departure point, the object of the invention is to specify a connection method for data transmission lines and a plug connector, in particular for carrying out this method, with which propagation delay differences can be reduced.

As regards the method, this object is achieved by means of a method having the features of Patent Claim 1. Preferred developments emerge from subclaims 2 and 3.

It is advantageous that the propagation delay difference between two conductors can be reduced in small steps. This is achieved by virtue of the fact that during the method of producing a connection of plug connector and data transmission line, the propagation delay difference between the conductors is measured and it is possible to remove or sever individual conductor sections from the conductive structure in the plug connector, which leads to an altered propagation delay in the plug connector.

As regards the arrangement, the object is achieved by means of an arrangement having the features of Patent Claim 4. Preferred developments emerge from Subclaims 5 to 10.

It is advantageous that the plug connector can be used together with different data transmission lines having various propagation delay errors. This is achieved by virtue of the fact that each conductor in the plug connector is connected to a plug transfer contact, by means of an essentially identical conductive structure, comprising identical conductor sections. This conductive structure can then be processed in such a way that it is possible to compensate for various propagation delay differences.

It is furthermore advantageous that the plug connector is simple to produce. This is achieved by virtue of the fact that both the conductor connection contacts and the plug transfer contacts as well as the conductive structure can be produced from a single stamping. This is also achieved by virtue of the fact that the conductive structure is arranged on a printed circuit board or is produced from a metallized plastic substrate.

An exemplary embodiment of the invention is explained with reference to the drawings, in which:
Figure 1 shows a perspective illustration of a plug connector which is cut open in the longitudinal axis parallel to the plane of the conductive structures, before the data transmission line has been connected to the plug connector and before the propagation delay difference between conductors has been compensated for; and
Figure 2 shows a perspective illustration of the same plug connector after the data transmission line has been connected to the plug connector and after the propagation delay difference between the conductors has been compensated for.

The plug connector 1 comprises a housing 2 with a conductor connection side 3 and a plug transfer side 5. The housing 2 comprises a cover part 7 and a base part 9 matching the latter. On the conductor connection side 3, the housing 2 has two conductor connection contacts 4, 4', which are designed as an insulation displacement contact. On the plug transfer side 5, the housing 2 has two plug transfer contacts 8, 8', which are designed as blade pins. The blade pins are angled at one end in such a way that the plug transfer contacts 8, 8' can be introduced in a clamping manner into metallized holes in a printed circuit board. The conductor connection contacts 4, 4' are respectively connected by means of a conductive structure 6, 26 to the plug transfer contacts 8, 8'. The conductive structure 6, 26 comprises a plurality of individual conductor sections 10, which are multiply connected to one another at crossover points 12. The conductive structure 6, 26 may also have an essentially three-dimensional structure.

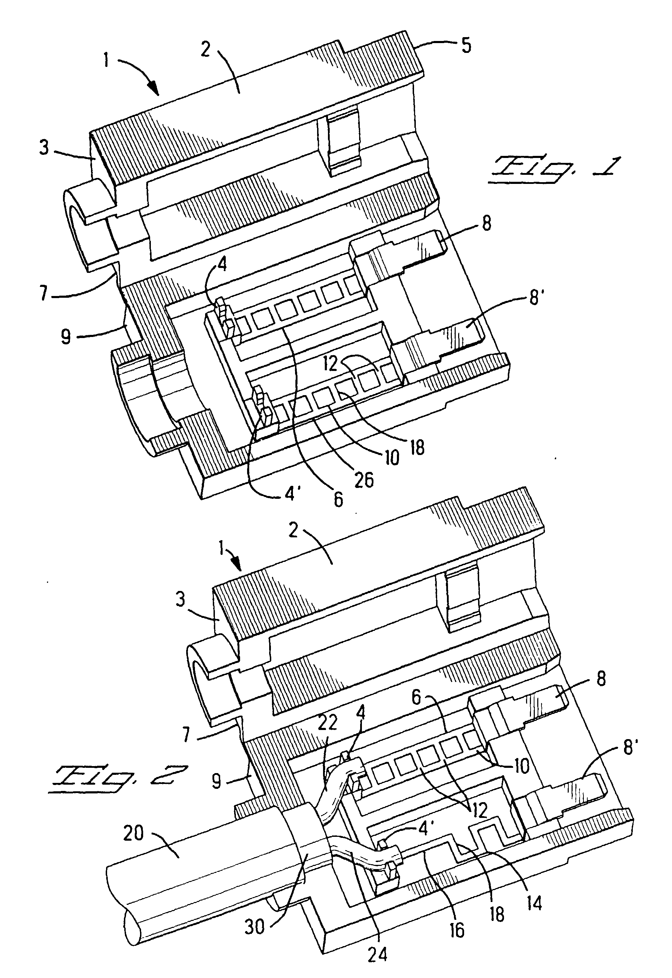

In Figure 1, the conductive structures 6, 26 are designed identically for both conductors 22, 24. Each conductive structure 6, 26 comprises two longitudinal conductor sections 16 which have the same length and represent an electrical current path of identical length for the connection of the conductor connection contact 4, 4' to the plug transfer contact 8, 8'. The longitudinal conductor sections 16 are connected at a plurality of crossover points 12 by means of a plurality of transverse conductor sections 18. The length of the path covered by the electrical current is identical for both conductive structures 6, 26 within the plug connector 2. Figure 1 illustrates the state of the plug connector 1 before a data transmission line 20 has been connected.

Figure 2 illustrates the state after the data transmission line 20 has been connected and after the propagation delay difference between the two conductors 22, 24 has been measured and, as far as possible, compensated for. The data transmission line 20 comprises two conductors 22, 24. At least one end 30 of the data transmission line 20 is connected to a plug connector 1. The data transmission line 20 and the housing 2 are electromagnetically screened. At the end 30, the electromagnetic screens of the data transmission line 20 and the housing 2 are connected to one another.

In Figure 2, various conductor sections have been removed from one of the conductive structures 6, 26. Whereas the first conductive structure 6 for the first conductor 22 is still identical to the conductive structures of Figure 1, the second conductive structure 26 for the second conductor 24 has an altered conductor track 14.

Since individual conductor sections 10 have been removed from the longitudinal conductor section 16 in the case of the conductive structure 26 on the side of the second conductor 24, the second conductive structure 26 on the side of the conductor 24 represents a longer path for the electrical current than the first conductive structure 6 on the side of the first conductor 22.

The method for producing a connection of data transmission lines comprises the following method steps:

In a preparation step, a data transmission line 20 is connected to the plug connector 1. For this purpose, the conductors 22, 24 are fixed to the conductor connection contacts 4, 4' by means of insulation displacement contact technology.

In the next step, the propagation delay difference between signals on the first conductor 22 and on the second conductor 24 is measured. Since, prior to the measurement, the plug connector 1 has the same conductive structure 6, 26, the same conductor connection contacts 4, 4' and the same plug transfer contacts 8, 8' for both conductors 22, 24, it is possible to measure the propagation delay difference of the data transmission line 20 by way of the combination of the line 20 and the plug connector 1. In this way, any further propagation delay differences which may arise within the plug connector 1 are also taken into account in the propagation delay measurement.

In the next step, an individual conductor section 10 is removed from a longitudinal conductor section 16 in the case of the conductor 24, for which a shorter propagation delay has been measured than for the other conductor 22. As a result, the path on this conductor and hence the propagation delay are lengthened.

The propagation delay difference between the first conductor 22 and the second conductor 24 is then measured once again.

In the next step, firstly an individual conductor section 10 is once again removed from a longitudinal conductor section 16 between two crossover points 12, to be precise also on the side of the conductor 24 for which the shorter propagation delay was measured in the preceding step.

The propagation delay difference between the first conductor 22 and the second conductor 24 is then once again measured, as described above. The result of this second propagation delay measurement will be smaller than the result of the first propagation delay measurement.

The difference between the first and the second measurement is to be attributed to the conductor section 10 just removed. On that side of the conductor 22, 24 where the current path is lengthened by the removal of conductor sections 10, the propagation delay becomes longer and the difference between the propagation delay of the first conductor 22 and the propagation delay of the second conductor 24 becomes smaller.

The method steps of measurement and removal can be repeated several times in succession. After each removal of a further conductor section 10, a smaller propagation delay difference is measured. When the propagation delay difference measured in this way is smaller than half of the decrease between two successive measurements, further removal of a conductor section 10 will no longer result in an improvement in the propagation delay difference.

The combination of data transmission line 20 and plug connector 1 is now optimally matched with regard to the propagation delay difference between the individual conductors 22, 24.

The conductor sections 10 are removed by being broken out, by milling, by etching or by means of laser beam processing.

Should the optimum be missed, because one conductor section 10 too many has been removed on one side, then it is likewise possible to remove an individual conductor section 10 from the still intact conductive structure 6 on the opposite side.

The measurement necessitates a very accurate apparatus which simulates data transmission at a very high data rate.

The cover part 7 and the base part 9, which matches the latter, of the housing 2 are connected to one another in a clamping manner by means of a push-button mechanism (not shown here).

When the two housing parts are joined together, the electromagnetic screening of the housing 2 is also achieved.

## Claims

1. Method for producing a connection for data transmission lines, which comprises the following steps:
connecting a data transmission line (20), having at least two conductors (22, 24) at one end (30) to a plug connector (1), having respective conductor connection contacts (4, 4') which are connected by means of a corresponding conductive structure (6, 26) to a corresponding plug transfer contact (8, 8'), where at least one of the conductive structures is structured in such a way to be adaptable in length; measuring any propagation delay differences to a mating device; and modifying the length of one of the conductive structures (6, 26) such that a conductor track (14) results, whereby propagation delay differences are reduced.

2. The method of Claim 1 for producing a connection of data transmission lines, characterized in that the conductive structure (6, 26) is made from a plurality of individual conductor sections (10) connected to one another at crossover points (12), and modifying is accomplished by the removal or severing of at least one of the conductor sections (10).

3. The method of Claim 1 or Claim 2 for producing a connection of data transmission lines, characterized in that the step of connecting the conductors is accomplished by insulation displacement contact techniques.

4. A plug connector, for data transmission lines having at least two conductors (22, 24); comprising: a housing (2) having at least two conductor connection contacts (4, 4'), connected to corresponding plug transfer contacts (8, 8') by corresponding conductive structures (6, 26), characterized in that at least one conductive structure (6, 26) has individual conductor sections (10) connected to one another at crossover points (12), and that it is possible to produce different conductor tracks (14) having different lengths by severing or removing various conductor sections (10) of the conductive structure (6, 26).

5. Plug connector according to Claim 4, characterized in that the conductive structure (6, 26) comprises at least two longitudinal conductor sections (16) which are arranged parallel, are connected to the conductor connection contacts (4, 4') and plug transfer contacts (8, 8'), have the same length and are connected by means of further transverse conductor sections (18).

6. Plug connector according to either of Claims 4 and 5, characterized in that the conductor connection contacts (4, 4') are designed as an insulation displacement contact.

7. Plug connector according to one of Claims 4 to 6, characterized in that the plug transfer contacts (8, 8') are designed as blade pins.

8. Plug connector according to one of Claims 4 to 7, characterized in that the plug transfer contacts (8, 8') are of angled design and can be introduced in a clamping manner into metallized holes in a printed circuit board.

9. Plug connector according to one of Claims 4 to 7, characterized in that the conductive structure (6, 26) is designed as a stamping.

10. Plug connector according to one of Claims 4 to 8, characterized in that the conductive structure (6, 26) is designed on a printed circuit board.

11. Plug connector according to one of Claims 4 to 8, characterized in that the conductive structure (6, 26) is designed as a plastic structure coated with metal.

## Patentansprüche

1. Verfahren zur Herstellung einer Verbindung für Datenübertragungsleitungen, das folgende Schritte umfasst:
Verbinden einer Datenübertragungsleitung (20), mit mindestens zwei Leitern (22, 24) an einem Ende (30), mit einem entsprechenden Steckverbinder (1), mit jeweils einem Leiteranschlusskontakt (4, 4'), der mittels einer entsprechenden leitenden Struktur (6, 26) mit einem entsprechenden Steckerübergabekontakt (8, 8') verbunden ist, wobei mindestens eine der leitenden Strukturen derart strukturiert ist, dass sie in der Länge adaptierbar ist; Messen jeder Laufzeitdifferenzen zu einer Eingriffs-vorrichtung; und Modifizieren der Länge einer der leitenden Strukturen (6, 26) so dass eine Leiterbahn (14) entsteht, wobei die Laufzeitdifferenzen reduziert werden.

2. Verfahren nach Anspruch 1 zur Herstellung einer Verbindung von Datenübertragungsleitungen, dadurch gekennzeichnet, dass die leitende Struktur (6, 26) aus mehreren einzelnen Leiterabschnitten (10) aufgebaut ist, welche an Kreuzungspunkten (12) miteinander verbunden sind, und das Modifizieren wird ausgeführt durch Entfernen oder Durchtrennen mindestens einer der Leiterabschnitte (10).

3. Verfahren nach Anspruch 1 oder 2 zur Herstellung einer Verbindung von Datenübertragungsleitungen, dadurch gekennzeichnet, dass der Schritt des Verbindens der Leiter mittels Schneidklemmtechniken ausgeführt wird.

4. Steckverbinder für Datenübertragungsleitungen mit mindestens zwei Leitern (22, 24); umfassend: ein Gehäuse (2) mit mindestens zwei Leiteranschlusskontakten (4, 4'), die mit entsprechenden Steckerübergabekontakten (8, 8') verbunden sind mittels entsprechenden leitenden Strukturen (6, 26), dadurch gekennzeichnet dass mindestens eine leitende Struktur (6, 26) einzelne Leiterabschnitte (10) aufweist, die an Kreuzungspunkten (12) miteinander verbunden sind, und dass durch das Durchtrennen oder Entfernen verschiedener Leiterabschnitte (10) der leitenden Struktur (6, 26) unterschiedliche Leiterbahnen (14) herstellbar sind, die unterschiedliche Längen aufweisen.

5. Steckverbinder nach Anspruch 4, dadurch gekennzeichnet, dass die leitende Struktur (6, 26) mindestens zwei parallel angeordnete, mit den Leiteranschlusskontakten (4, 4') und Steckerübergabekontakten (8, 8') verbundenen gleich langen Längsleiterabschnitten (16) umfasst, die mittels weiteren Querleiterabschn-itten (18) verbunden sind.

6. Steckverbinder nach einem der Ansprüche 4 oder 5, dadurch gekennzeichnet, dass die Leiteranschlusskontakte (4, 4') als Schneidklemmverbindung ausgeführt sind.

7. Steckverbinder nach einem der Ansprüche 4 bis 6, dadurch gekennzeichnet, dass die Steckerübergabekontakte (8, 8') als Flachstifte ausgeführt sind.

8. Steckerverbinder nach einem der Ansprüche 4 bis 7, dadurch gekennzeichnet, dass die Steckerübergabekontakte (8, 8') abgewinkelt ausgeführt sind und klemmend in metallisierten Bohrungen in einer gedruckten Schaltungsplatte einbringbar sind.

9. Steckverbinder nach einem der Ansprüche 4 bis 7, dadurch gekennzeichnet, dass die leitende Struktur (6, 26) als Stanzteil ausgeführt ist.

10. Steckverbinder nach einem der Ansprüche 4 bis 8, dadurch gekennzeichnet, dass die leitende Struktur (6, 26) auf einer gedruckten Schaltungsplatte ausgeführt ist.

11. Steckverbinder nach einem der Ansprüche 4 bis 8, dadurch gekennzeichnet, dass die leitende Struktur (6, 26) als eine mit Metall beschichtete Kunststoff Struktur ausgeführt ist.

## Revendications

1. Procédé de production d'une connexion pour des lignes de transmission de données, comprenant les étapes ci-dessous:
connexion d'une ligne de transmission de données (20), comportant au moins deux conducteurs (22, 24) au niveau d'une extrémité (30) à un connecteur à fiche (1), comportant des contacts de connexion de conducteurs respectifs (4, 4'), connectés par l'intermédiaire d'une structure conductrice correspondante (6, 26) à un contact de transfert de fiche correspondant (8, 8'), au moins une des structures conductrices étant structurée de sorte à pouvoir être adaptée en longueur; mesure de quelconques différences du temps de propagation par rapport à un dispositif d'accouplement; et modification de la longueur de l'une des structures conductrices (6, 26), de sorte qu'il en résulte un tracé conducteur (14) permettant de réduire les différences du temps de propagation.

2. Procédé selon la revendication 1 pour la production d'une connexion de lignes de transmission de données, caractérisé en ce que la structure conductrice (6, 26) est composée de plusieurs sections de conducteur individuelles (10), connectées au niveau de points de croisement (12), une modification étant réalisée par l'enlèvement ou la séparation d'au moins une des sections de conducteur (10).

3. Procédé selon les revendications 1 ou 2 pour la production d'une connexion de lignes de transmission de données, caractérisé en ce que l'étape de connexion des conducteurs est réalisée par des techniques à contact autodénudant.

4. Connecteur à fiche pour des lignes de transmission de données comportant au moins deux conducteurs (22, 24); comprenant: un boîtier (2) comportant au moins deux contacts de connexion des conducteurs (4, 4'), connectés à des contacts de transfert de fiche correspondants (8, 8') par des structures conductrices correspondantes (6, 26), caractérisé en ce qu'au moins une structure conductrice (6, 26) comporte des sections de conducteur individuelles (10), connectées au niveau de points de croisement (12) et en ce qu'il est possible de produire différents tracés conducteurs (14) ayant des longueurs différentes par séparation ou enlèvement de différentes sections de conducteur (10) de la structure conductrice (6, 26).

5. Connecteur à fiche selon la revendication 4, caractérisé en ce que la structure conductrice (6, 26) comprend au moins deux sections de conducteur longitudinales (16) agencées parallèlement, connectées aux contacts de connexion des conducteurs (4, 4') et aux contacts de transfert de fiche (8, 8'), de longueur identique et connectées par l'intermédiaire de sections de conducteur transversales supplémentaires (18).

6. Connecteur à fiche selon l'une des revendications 4 et 5, caractérisé en ce que les contacts de connexion des conducteurs (4, 4') sont conçus sous forme d'un contact autodénudant.

7. Connecteur à fiche selon l'une des revendications 4 à 6, caractérisé en ce que les contacts de transfert de fiche (8, 8') ont une forme de broches à lames.

8. Connecteur à fiche selon l'une des revendications 4 à 7, caractérisé en ce que les contacts de transfert de fiche (8, 8') ont une forme angulaire et peuvent être introduits par serrage dans des trous métallisés dans une plaquette de circuits imprimés.

9. Connecteur à fiche selon l'une des revendications 4 à 7, caractérisé en ce que la structure conductrice (6, 26) a la forme d'une pièce estampée.

10. Connecteur à fiche selon l'une des revendications 4 à 8, caractérisé en ce que la structure conductrice (6, 26) est formée sur une plaquette de circuits imprimés.

11. Connecteur à fiche selon l'une des revendications 4 à 8, caractérisé en ce que la structure conductrice (6, 26) a la forme d'une structure plastique revêtue de métal.
